# EUROPEAN PATENT SPECIFICATION

(11) **EP 1 862 807 B1**
(45) Date of publication and mention of the grant of the patent: **18.08.2010**
(21) Application number: 06114900.1
(22) Date of filing: 02.06.2006
(51) Int. Cl.: G01R 31/00

(54) **Electrostatic discharge device testing system and method**
Testsystem und verfahren für eine elektrostatische Entladungsvorrichtung
Système et procédé de tests du dispositif de décharge électrostatique

(43) Date of publication of application: 05.12.2007
(60) Divisional application: 10152979.0
(73) Proprietor: RESEARCH IN MOTION LIMITED, Waterloo, Ontario N2L 3W8 (CA)
(72) Inventor: Enta, Roger, Waterloo Ontario N2L 3W8 (CA)
(74) Representative: MERH-IP Matias Erny Reichl Hoffmann

(56) References cited:
- EP-A- 0 580 913
- WO-A-99/09792
- WO-A-99/28754
- US-A- 5 083 117
- US-A- 5 969 626
- US-A- 6 052 053
- US-A1- 2003 234 651
- US-B1- 6 510 987

## Description

The present invention relates generally to the field of electrostatic discharge (ESD) testing systems and methods.

Monitoring and controlling electrostatic discharge or ESD is an important function in electronics manufacturing, since uncontrolled discharge may seriously damage ESD-sensitive components. Damage often occurs at a microscopic level, such that the actual damage to a component may only be discovered in testing after manufacture, or after premature failure experienced by an end user.

Various ESD monitoring devices and ESD protection devices are available to help manage the risk of ESD during manufacturing and assembly of sensitive electronic components and devices. For example, an ESD monitoring device may monitor environmental conditions such as temperature and humidity, and may trigger an alarm if these conditions fall outside a preferred operating range. An ESD protection device may include, for example, an ESD safe mat for neutralizing static charge on the table of an electronics assembly station. Another example of an ESD protection device is an ESD floor mat or flooring that may be used for electrically grounding an operator that may touch sensitive electronic components and devices during assembly.

In order to ensure that the ESD monitoring and protection devices within an electronics manufacturing or assembly facility are functioning properly, it is desirable to test them at regular intervals using ESD device testers. A device tester commonly used for this purpose is a megohmmeter that may be used to measure the resistance of an ESD monitoring or protection device. The resistance measured by the megohmmeter may provide an indication of the potential of an ESD monitoring or protection device to prevent ESD.

Presently, to test these various ESD monitoring and protection devices, an ESD specialist typically sets the megohmmeter to take a resistance measurement for an ESD monitoring or protection device, obtains a resistance measurement, and logs the measurement on a log sheet. This is repeated for each and every device. While functional, this approach can become tedious and cumbersome when many devices must be tested at a facility.

What are needed are systems and methods for more efficiently testing and obtaining measurements for ESD monitoring or protection devices.
WO-A-99/09792 discloses an automated system for checking ESD device efficacy verification and recording the results. The system includes different testing units for different devices such as a mat for testing ESD footwear and connectors for testing wrist strap. Not all users will carry the same ESD equipment. For example some may wear wrist straps and ESD footwear whilst others may have only the footwear. In use, each worker identifies himself to the system. Information as to which worker has which equipment is pre-programmed into the system so that the system can prompt the worker to carry out the tests appropriate to the equipment he has. Workers may select different resistance levels in the course of the test procedure.
US-A-6052053 discloses another automated system for performing ESD device efficacy testing and logging the results. A central computer collects, stores and allows the manipulation of test data.
EP-A-0580913 discloses a system for testing ESD equipment which, in the case of an ESD wrist strap, is able to detect faults with the wiring to ground as well as the strap itself.
Portable devices for specific applications are also known. For example, WO-A-99/28754 discloses a portable device for detecting precipitation static interference sources in aircraft.
The present invention provides, in one aspect, a portable electrostatic discharge (ESD) device tester as defined in claim 1.
In another aspect the invention provides a computer readable medium storing computer code as defined in claim 8.

### BRIEF DESCRIPTION OF THE DRAWINGS

In the figures which illustrate exemplary embodiments of the invention:
FIGS. 1A is an illustration of an ESD device tester in accordance with an embodiment;
FIG. 1B is a schematic block diagram of the ESD device tester of FIG. 1A;
FIG. 2 is a schematic diagram of an electronics manufacturing/assembly facility having a plurality of ESD monitoring and protection devices;
FIG. 3 is a schematic diagram of one of the stations in the facility of FIG. 2 configured for testing using the system of FIGS. 1A & 1B in accordance with an embodiment;
FIG. 4 is an illustrative table of test measurement data stored on the ESD device tester of FIGS. 1A & 1B;
FIG. 5 is a flowchart of an illustrative method in accordance with an embodiment.

### DESCRIPTION OF PREFERRED EMBODIEMNTS

As noted above, the present invention relates to electrostatic discharge monitoring systems and methods.

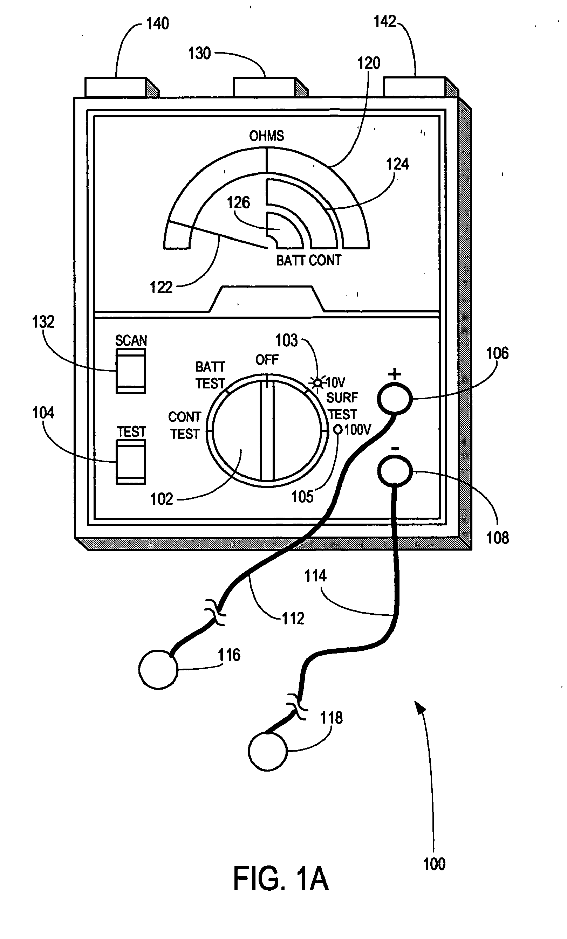

Shown in FIG. 1A is an illustration of an ESD device tester 100 in accordance with an embodiment. ESD device tester 100 may be, for example, a megohmmeter for measuring the resistance of an ESD device. Any suitable megohmmeter may be used. As an example, ESD device tester 100 may be a suitably modified version of the 3M™Model 701 Megohmmeter manufactured by 3M Electronic and Interconnect Solutions Division of Austin, Texas.

ESD device tester 100 may include a selector switch 102 for selecting one of a plurality of testing modes including, for example, a continuity test mode, a battery test mode, a 10V surface test mode, and a 100V surface test mode. Selector switch 102 may also be used to place ESD device tester 100 into an "off' mode. The battery test mode may be used to test the internal battery powering the ESD device tester 100. The continuity test mode may be used to test the leads 112, 114 to determine if they are functioning properly. Finally, the surface test mode may be used to test the resistance measurement of a surface to be tested. Light emitting diodes or LEDs 103, 105 may be used to identify the appropriate setting to be used, as described further below. These test modes will be described in greater detail below.

Still referring to FIG. 1A, ESD device tester 100 may include a test button to activate the test function selected using selector 102. Testing may be performed using test leads 112, 114 connected to positive and negative terminals 106 and 108, respectively. At the opposite end of the test leads 112, 114, a pair of contact pads 116, 118 may be provided to make contact with a target surface to be measured. Once the test leads 112, 114 have been connected using contact pads 116, 118 to appropriate locations on a target surface and a test measurement has been taken by actuating test button 104, the result may be read on a user interface / display provided on the megohmmeter. For example, an indicator 122 may be configured to move along one of the scales 120, 124, 126 provided. If a surface test is being conducted, the measurement may be indicated by movement of an indicator 122 along the megohmmeter resistance scale 120. If a continuity test is being conducted, the measurement indicated by movement of the indicator 122 along the continuity scale 124 may be used. Finally, for battery testing, the measurement may be indicated by movement of the indicator 122 along the battery scale 126.

Still referring to FIG. 1A, shown is a barcode-reader 130 that may be integrated into ESD device tester 100 and used to scan a unique barcode label provided on each ESD device to be tested using device tester 100. Alternatively, a radio frequency identification (RFID) tag reader may be used to read RFID tags provided in each ESD device to be tested. These identification means will be described in more detail further below.

In addition to the barcode reader 130, ESD device tester 100 may further include a temperature sensor 140 and a humidity sensor 142. Temperature sensor 140 and humidity sensor 142 may be used to test environmental conditions in the immediate vicinity of an ESD device being tested. These sensors 140, 142 may be used independently, or alternatively may be activated at the same time that barcode reader 130 is activated using scan button 132, for example.

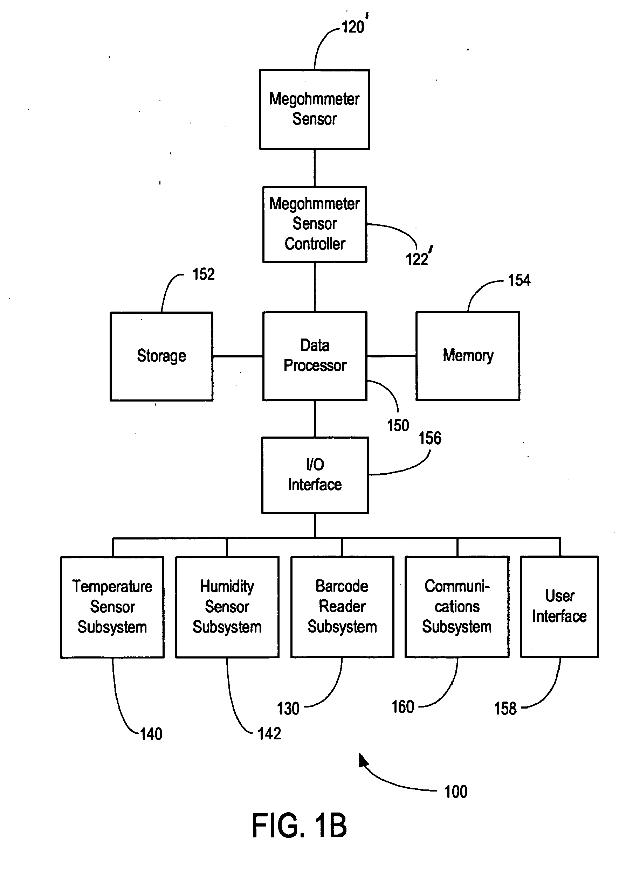

FIG. 1B shows a schematic block diagram of various components of the ESD device tester 100 of FIG. 1A. By way of example, ESD device tester 100 may include a megohmmeter sensor 120' suitably configured to perform surface tests as previously described. Megohmmeter sensor 120' may be operatively connected by a suitable interface controller 122' to data processor 150. Data processor 150 may be operatively connected to storage 152 and to memory 154. Memory 154 may be a suitable random access memory for temporarily storing data required by data processor 150. Storage 152 may be a non-volatile storage that may be used as an input or produced as an output by data processor 150. Data processor 150 may also be operatively connected via an I/O interface 156 to a user interface 158, a barcode reader subsystem 130, and a wireless communications subsystem 160.

User interface 158 may incorporate a suitable display viewable by an ESD specialist which may be, for example, an analog dial as shown in FIG. 1A. The display may alternatively be a suitable digital graphical display to provide the ESD specialist with multiple pieces of information.

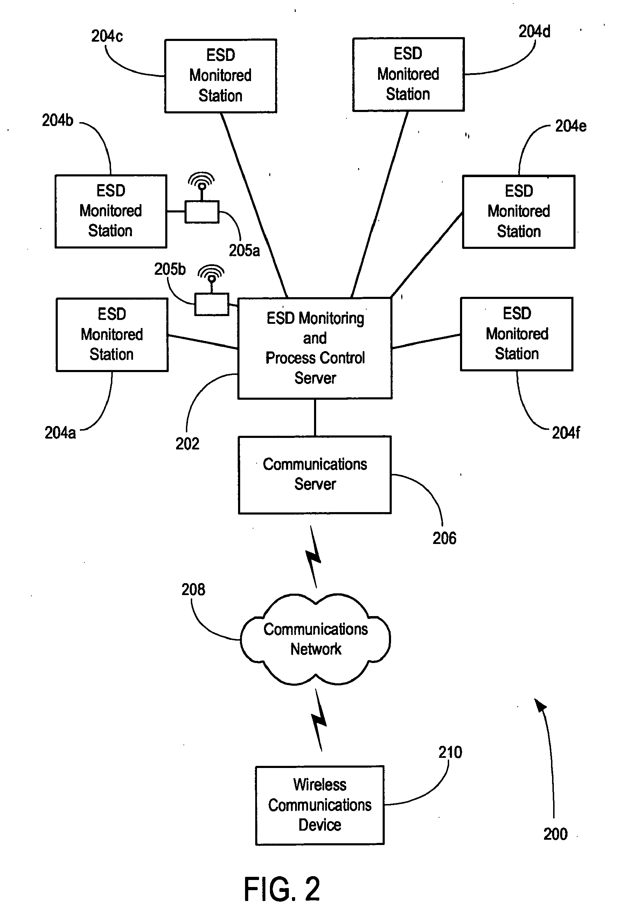

FIG. 2 is a schematic diagram of an electronics manufacturing/assembly facility 200 having a plurality of ESD monitoring and protection devices. For example, facility 200 may comprise an electronics assembly line having a plurality of ESD monitored stations 204a - 204f. ESD monitored stations 204a - 204f may be operatively connected to and controlled by an ESD monitoring and process control server 202. Certain ESD monitored stations (e.g. 204b) may be operatively connected to ESD monitoring and processor control server 202 using a pair of transceivers 205a, 205b. ESD monitoring and process control server 202 may also be operatively connected to a communications server 206. Communications server 206 may be operatively connected via a communications network 208 to a mobile communications device 210. As will be further explained below, in an embodiment, ESD device tester 100 may be enabled for wireless communications with ESD monitoring and process control server 202.

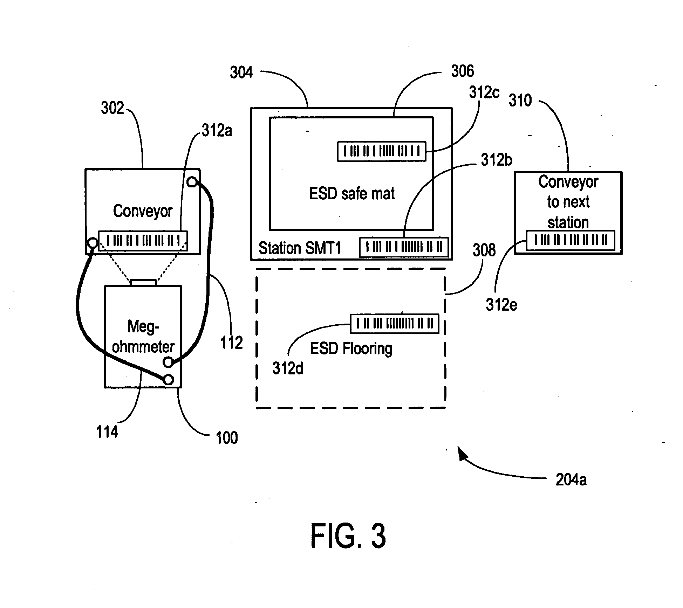

Now referring to FIG. 3, shown is a schematic diagram of one of the stations (e.g. 204a) in the facility 200 in FIG. 2. As shown, each ESD device located at station 204a is uniquely identified using a barcode label. For example, a conveyor 302 which delivers an electronics assembly to station 204a may be identified using a barcode label 312a. Similarly, ESD table 304 may be uniquely identified using barcode label 312b, ESD safe mat 306 may be uniquely identified using barcode label 312c, ESD flooring 308 may be uniquely identified using barcode label 312d, and conveyer 310 to the next station may be uniquely identified using barcode label 312e.

Still referring to FIG. 3, ESD device tester 100 may be used to test each device 302, 304, 306, 308, 310 at station 204a. In accordance with an embodiment, prior to testing each ESD device 302, 304, 306, 308, 310, the barcode reader subsystem 130 of ESD device tester 100 may be used to uniquely identify the ESD device. For example, as shown earlier in FIG. 1A, scan button 132 may be actuated to initiate a barcode scan using barcode reader subsystem 130.

By uniquely identifying the ESD device to be tested, ESD device tester 100 can be configured to record a subsequent surface test measurement and associate that surface test measurement to that specific device. For example, as shown in FIG. 3, ESD device tester 100 is reading barcode 312a which uniquely identifies conveyor 302. Test leads 112, 114 are shown connected to suitable connection points on conveyor 302. Upon selecting the type of test to be conducted using the ESD device tester 100, the measurement taken at conveyor 302 using megohmmeter sensor 120' (FIG. 1B) may be processed by data processor 150, and stored in non-volatile storage 152.

In an embodiment, non-volatile storage 152 may store code that when loaded into data processor 150 configures the data processor 150 to uniquely identify the ESD device 302, 304, 306, 308, 310 being tested, and to retrieve from storage (e.g. storage 152) data associated with that unique ESD device. Storage 152 may store data that specifies one or more operational settings in ESD device tester 100. For example, if a particular ESD device requires a certain voltage setting for proper operation (e.g. 10V or 100V surface test), ESD device tester 100 may be configured to retrieve the necessary setting. If the voltage setting is to be done automatically, this setting on ESD device tester 100 may be configured to be adjustable without manually turning selector 102 (FIG. 1). Alternatively, a suitable indicator, such as an LED (e.g. LED 103 or 105 of FIG. 1), may be used to indicate the appropriate voltage setting to be used for the particular ESD device 302, 304, 306,308,310.

In an embodiment, in addition to providing specific settings to be used by ESD device tester 100, ESD device tester 100 may also store historical information for test measurements of that device. For example, as will be explained in more detail below, storage 152 of ESD device tester 100 may be used to store the last measured test value for the ESD device 302, 304, 306, 308, 310. In an embodiment, ESD device tester 100 may also be used to identify any significant discrepancy from a previously stored test measurement for a particular ESD device, indicating a possible problem with the ESD device 302, 304, 306, 308, 310, the ESD device tester 100, or perhaps that the test was not properly done. In this manner, the ESD specialist may be alerted immediately so that another confirmation test may be taken using the ESD device tester 100.

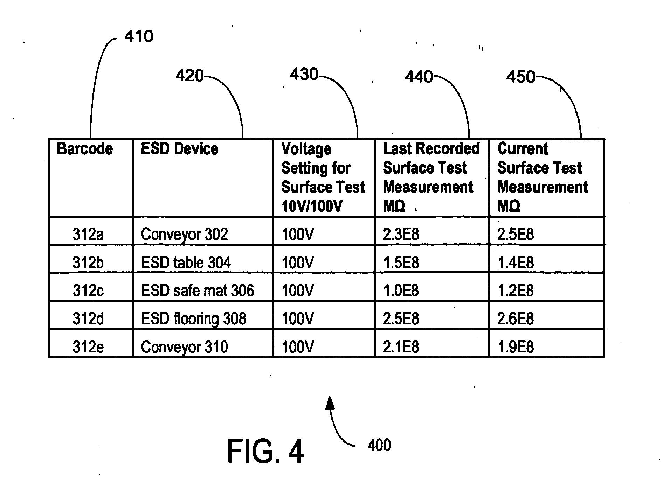

FIG. 4 is an illustrative table of sample test measurement data 400 stored on the ESD device tester of FIG. 1 (e.g. in storage 152). As shown, a first column 410 may include a plurality of unique barcode values that uniquely identify each of the ESD devices 302 - 310 listed in column 420. A column 430 may specify the appropriate voltage setting for each ESD device in column 420. Another column 440 may store the last recorded surface test measurement for each ESD device in column 420. Another column 450 may store the current surface test measurement for each ESD device in column 420.

In an embodiment, instead of or in addition to a last recorded surface test measurement for each ESD device in column 420, a running average of surface test measurements for each ESD device may be stored. This may allow the ESD specialist to compare the current test measurement for a particular ESD device to an average test measurement taken over a longer period of time (e.g. an average of the last ten measurements).

The data stored in the table in FIG. 4 may allow an ESD specialist to test ESD devices 302 - 310 more efficiently by uniquely identifying the ESD device 302, 304, 306, 308, 310 to be tested, retrieving and applying any settings for the ESD device tester 100 specific to that ESD device 302, 304, 306, 308, 310, and optionally retrieving a history or average of previous test measurements to validate the current test measurements that are taken.

In another embodiment, temperature sensor 140 and humidity sensor 142 may be used to test environmental conditions in the immediate vicinity of an ESD device being tested and these temperature and humidity measurements may be stored together with the surface resistance measurements to help interpret any variations in surface resistance test measurements.

In a further embodiment, in addition to retrieving data and configuring the ESD device tester 100 in some manner (e.g. applying specific test settings for the device), user instructions for correct placement of test leads 112, 114 may also be retrieved depending on the type of ESD device in column 420. For example, based on the unique identification provided by the barcode value in column 410, appropriate text instructions may be provided via a display in user interface 158. The text instructions may, for example, guide a user to place test leads 112, 114 on marked test points provided on a type of ESD device. Alternatively, a graphic of the particular ESD device may be provided to visually identify the location of the test contact points to be used for the particular type of ESD device. Rather than being individual to each ESD device, the text instructions or graphic may be stored for a finite number (e.g. 6 to 12) of different kinds of ESD devices that may be tested using ESD device tester 100.

In an embodiment, the data stored in the table in FIG. 4 may be uploaded from ESD device tester 100 to a host server, such as the ESD monitoring and process control server 202 of FIG. 1. This may be done either by connecting ESD device tester 100 directly to server 202 via a suitable connector (e.g. via serial, parallel, universal serial bus (USB), or FireWire), or if ESD device tester 100 is also configured with a wireless communications subsystem 160, then wirelessly via communications network 208 and communications server 206 (FIG. 2).

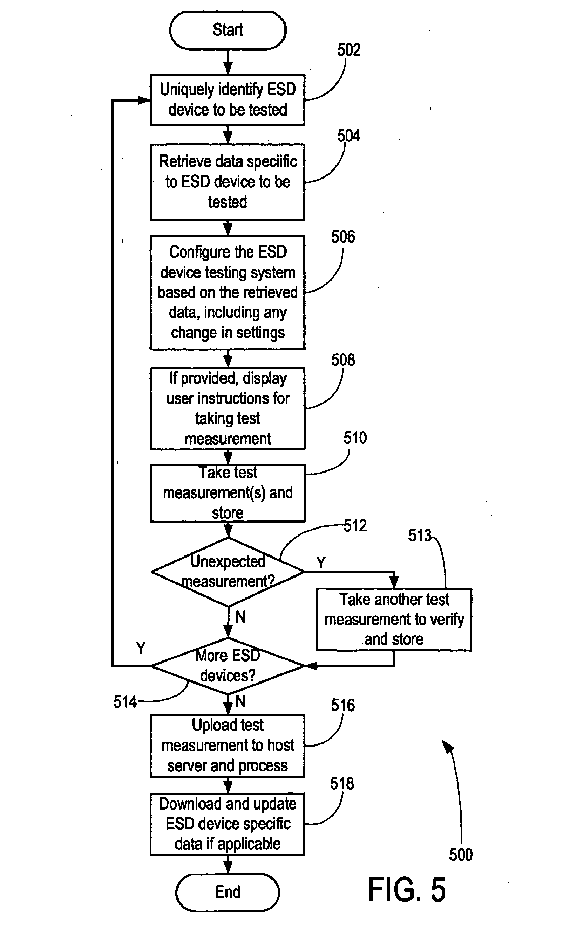

FIG. 5 is a flowchart of an illustrative method 500 in accordance with an embodiment corresponding to the above description. At block 502, an ESD specialist may uniquely identify an ESD device to be tested (e.g. using a barcode reader subsystem 130 integrated into ESD device tester 100). Upon unique identification of the ESD device to be tested, method 500 proceeds to block 504, where data specific to the ESD device to be tested may be retrieved (e.g. from non-volatile storage 152). Upon retrieval of the data, method 500 proceeds to block 506 where the ESD device tester 100 is configured based on the retrieved data. This may include, for example, configuring ESD device tester 100 to be ready to accept a test measurement value.

As previously described, the retrieved data may also include a particular setting for the ESD device tester 100 specific to that ESD device. The retrieved data may also include historic measurement data for the ESD device which may include, for example, the last recorded test measurement, or some average of a plurality of previously recorded test measurements.

At block 508, as a test measurement is taken, if the retrieved data includes instructions on how the testing should be performed (e.g. by providing text instructions or a graphic illustration on locating the correct contact points on a particular type of ESD device for testing) the data is displayed to the user so that the testing procedure will remain consistent from one test to the next even if performed by different individuals. This may help to ensure that any variations between successive test measurements are more meaningful.

Method 500 then proceeds to block 510, where one or more test measurements are taken (e.g. by actuating test button 104) and stored. For example, a test measurement may be taken for a surface test, as well as one or more of temperature and humidity.

If the retrieved data also includes historical test measurement data, method 500 may proceed to decision block 512 to determine if the measurement is unexpected (i.e. outside of a predetermined acceptable range of variation). If no, method 500 proceeds directly to decision 514 where, if there are more ESD devices to be tested, method 500 may return to block 502 to uniquely identify the next ESD device. If yes, method 500 may optionally proceed to block 513 to take another measurement to verify the test before proceeding to decision block 514.

At decision block 514, if there are no more ESD devices to be tested, method 500 may proceed to block 516 where the test measurement data stored on ESD device tester 100 may be uploaded to a host server (e.g. ESD monitoring and process control server 202 of FIG. 2) for processing. The processing may include, for example, updating a database of historical test measurement data for every ESD device tested. The historical test measurement data may be analyzed using various statistical methods.

In an embodiment, the result of any processing done on the host server may be downloaded back to the ESD device tester 100 in order to provide the ESD device specific data that may be retrieved during the next ESD testing at the electronics facility. Method 500 then ends.

It will be appreciated that the systems and methods as described above may assist an ESD specialist in conducting testing of numerous ESD devices at a facility in a more efficient manner.

Thus, in an aspect, there is provided a method of operating a portable electrostatic discharge (ESD) device tester, comprising: (i) uniquely identifying an ESD device to be tested using identification means provided on the tester; (ii) taking at least one test measurement of the uniquely identified ESD device using testing means provided on the tester, the testing means being configurable in dependence upon data associated with the uniquely identified ESD device; and (iii) storing the at least one test measurement in a storage means provided in the tester.

The method further comprises calculating a running average of test measurements for the uniquely identified ESD device.

The method further comprises comparing the at least one test measurement for the uniquely identified ESD device to the calculated running average of test measurements.

The method further comprises repeating a test measurement if the at least one test measurement is not within a predetermined range of the running average of test measurements for the uniquely identified ESD device.

The method further comprises transferring the at least one test measurement to a host server for processing.

In the invention, the testing means is a megohmmeter, the test measurement is a surface resistance test, and the method further comprises configuring the voltage to be used for the surface resistance test in dependence upon the uniquely identified ESD device.

In an embodiment, the identification means is one of a barcode reader and a radio frequency identification (RFID) tag reader, and the method further comprises reading a barcode or an RFID tag uniquely identifying an ESD device.

In another aspect, there is provided a portable electrostatic discharge (ESD) device tester, comprising: identification means for uniquely identifying an ESD device to be tested; testing means for taking at least one test measurement of the uniquely identified ESD device, the testing means being configurable in dependence upon data associated with the uniquely identified ESD device; and storage means for storing the at least one test measurement.

In an embodiment, the tester further comprises means for calculating a running average of test measurements for the uniquely identified ESD device.

In another embodiment, the tester further comprises means for comparing the at least one test measurement for the uniquely identified ESD device to the calculated running average of test measurements.

In another embodiment, the tester further comprises means for repeating a test measurement if the at least one test measurement is not within a predetermined range of the running average of test measurements for the uniquely identified ESD device.

In another embodiment, the tester further comprises means for transferring the at least one test measurement to a host server for processing.

In the invention, the testing means is a megohmmeter, the test measurement is a surface resistance test, and the system further comprises means for configuring the voltage to be used for the surface resistance test in dependence upon the uniquely identified ESD device.

In another embodiment, the tester further comprises means is one of a barcode reader and a radio frequency identification (RFID) tag reader.

In another aspect, there is provided a computer readable medium storing computer code that when loaded into a portable electrostatic discharge (ESD) device tester adapts the tester to obtain test measurements, the computer readable medium including: code for uniquely identifying an ESD device to be tested using identification means provided on the tester; code for taking at least one test measurement of the uniquely identified ESD device using testing means provided on the tester, the testing means being configurable in dependence upon data associated with the uniquely identified ESD device; and code for storing the at least one test measurement in a storage means provided in the tester.

In an embodiment, the computer readable medium further includes code for calculating a running average of test measurements for the uniquely identified ESD device.

In another embodiment, the computer readable medium further includes code for comparing the at least one test measurement for the uniquely identified ESD device to the calculated running average of test measurements.

In another embodiment, the computer readable medium further includes code for repeating a test measurement if the at least one test measurement is not within a predetermined range of the running average of test measurements for the uniquely identified ESD device.

In another embodiment, the computer readable medium further includes code for transferring the at least one test measurement to a host server for processing.

In the invention, the testing means is a megohmmeter, the test measurement is a surface resistance test, and the computer readable medium further includes code for configuring the voltage to be used for the surface resistance test in dependence upon the uniquely identified ESD device.

While illustrative embodiments have been described above, it will be appreciated that various changes and modifications may be made. More generally, the scope of the invention is defined by the following claims.

## Claims

1. A portable electrostatic discharge (ESD) device tester (100) to test a plurality of ESD devices at ESD monitored stations within an electronics manufacturing or assembly facility, wherein the ESD device tester (100) is a megohmmeter, the ESD device tester (100) comprising:
identification means (130) for uniquely identifying an ESD device (302, 304, 306, 308, 310) to be tested at one or more of the ESD monitored stations within the electronics manufacturing or assembly facility;
testing means (120', 140, 142) for taking at least one test measurement
of the uniquely identified ESD device (302, 304, 306, 308, 310), wherein the at least one test measurement is a surface resistance test;
configuration means (150, 152, 154) for automatically configuring the testing means (120', 140, 142) in dependence upon the data associated with the uniquely identified ESD device (302, 304, 306, 308, 310);
means (102) for configuring the voltage to be used for the surface resistance test in dependence upon the uniquely identified ESD device (302, 304, 306, 308, 310); and
storage means (152) for storing the at least one test measurement such that the tester (100) stores historical information for test measurements of the uniquely identified ESD device (302, 304, 306, 308, 310).

2. The tester (100) of claim 1 further comprising means (150, 152, 154) for calculating a running average of test measurements for the uniquely identified ESD device (302,304,306,308, 310).

3. The tester (100) of claim 2, further comprising means (150, 152, 154) for comparing the at least one test measurement for the uniquely identified ESD device (302, 304, 306, 308, 310) the calculated running average of test measurements.

4. The tester (100) of claim 3, further comprising means (120', 140, 142) for repeating a test measurement if the at least one test measurement is not within a predetermined range of the running average of test measurements for the uniquely identified ESD device (302, 304, 306, 308, 310).

5. The tester (100) of any one of claim 1 to 4, further comprising means (160) for transferring the at least one test measurement to a host server (202) for processing.

6. The tester of claim 1 further comprising means (140, 142) for taking at least one of temperature and humidity measurements together with the surface resistance test to help interpret any variations in the surface resistance test.

7. The tester (100) of any one of claim 1 to 6, wherein the identification means (130) is one of a barcode reader and a radio frequency identification (RFID) tag reader.

8. A computer readable medium (152) storing computer code that when loaded (150, 154) into a portable electrostatic discharge (ESD) device tester (100) adapts the tester (100) to obtain test measurements from a plurality of ESD devices at ESD monitored stations within an electronics manufacturing or assembly facility, wherein the tester (100) is a megohmmeter (100) and at least one of the test measurement is a surface resistance the computer readable medium including:
code for uniquely identifying an ESD device (302, 304, 306, 308, 310) to be tested using identification means (130) provided on the tester (100),
code for automatically configuring the testing means (120', 140, 142) provided on the tester (100) in dependence upon data associated with the uniquely identified ESD device (302, 304, 306, 308, 310);
code for adapting the tester (100) to configure the voltage to be used for the surface resistance test in dependence upon the identity of the uniquely identified ESD device (302, 304, 306,308,310);
code for taking at least one test measurement of the uniquely identified ESD device (302, 304, 306, 308, 310) using the testing means (120', 140, 142) provided on the tester (100); and
code for storing the at least one test measurement in a storage means (152) provided in the tester (100) such that the tester (100) stores historical information for test measurements of the uniquely identified ESD device (302,304, 306, 308, 310).

9. The computer readable medium of claim 8, further comprising code for adapting the tester (100) to calculate a running average of test measurements for the uniquely identified ESD device (302, 304, 306, 308, 310).

10. The computer readable of claim 9, further comprising code for adapting the tester (100) to compare the at least one test measurement for the uniquely identified ESD device (302, 304, 306, 308, to the calculated running average of test measurements.

11. The computer readable of claim 10, further comprising code for adapting the tester (100) to repeat a test measurement if the at least one test measurement is not within a predetermined range of the running average of test for the uniquely identified ESD device (302, 304, 306, 308, 310).

12. The computer readable medium of any one of claim 8 to 11, further comprising code for adapting the tester (100) to transfer the at least one test measurement to a host server (202) for processing.

13. The computer readable medium of claim 8 further comprising code for adapting the tester (100) to use at least one of temperature and humidity measurements together the surface resistance test to help interpret any variations in the surface resistance test.

14. The computer readable medium of any one of the preceding claims, wherein the identification means is one of a barcode reader and a radio frequency identification (RFID) tag reader, and the computer readable medium further comprises code for adapting the tester (100) to read a barcode or an RFID tag uniquely identifying an ESD device.

## Patentansprüche

1. Tragbare Testvorrichtung (100) für eine elektrostatische Entladungs(ESD - electrostatic discharge)-Vorrichtung zum Testen einer Vielzahl von ESD-Vorrichtungen an ESD-überwachten Stationen in einer Elektronik-Herstellungs- oder Fertigungseinrichtung, wobei die ESD-Vorrichtungs-Testvorrichtung (100) ein Megaohmmeter ist, wobei die ESD-Vorrichtungs-Testvorrichtung (100) aufweist:
Identifikationsmittel (130) zum eindeutigen Identifizieren einer ESD-Vorrichtung (302, 304, 306, 308, 310), die an einer oder mehreren der ESD-überwachten Stationen in der Elektronik-Herstellungs- oder Fertigungseinrichtung getestet werden soll;
Testmittel (120', 140, 142) zum Durchführen zumindest einer Testmessung der eindeutig identifizierten ESD-Vorrichtung (302, 304, 306, 308, 310), wobei die zumindest eine Testmessung ein Oberflächenwiderstandstest ist;
Konfigurationsmittel (150, 152, 154) zum automatischen Konfigurieren des Testmittels (120', 140, 142) abhängig von den Daten, die zu der eindeutig identifizierten ESD-Vorrichtung (302, 304, 306, 308, 310) gehören: Mittel (102) zum Konfigurieren der Spannung zur Verwendung für den Oberflächenwiderstandstest abhängig von der eindeutig identifizierten ESD-Vorrichtung (302, 304, 306, 308, 310); und
Speichermittel (152) zum Speichern der zumindest einen Testmessung derart, dass die Testvorrichtung (100) historische Information für Testmessungen der eindeutig identifizierten ESD-Vorrichtung (302, 304, 306, 308, 310) speichert.

2. Testvorrichtung (100) gemäß Anspruch 1, die weiter Mittel (150, 152, 154) aufweist zum Berechnen eines gleitenden Mittelwerts von Testmessungen für die eindeutig identifizierte ESD-Vorrichtung (302, 304, 306, 308, 310).

3. Testvorrichtung (100) gemäß Anspruch 2, die weiter Mittel (150, 152, 154) aufweist zum Vergleichen der zumindest einen Testmessung für die eindeutig identifizierte ESD-Vorrichtung (302, 304, 306, 308, 310) mit dem berechneten gleitenden Mittelwert von Testmessungen.

4. Testvorrichtung (100) gemäß Anspruch 3, die weiter Mittel (120', 140, 142) aufweist zum Wiederholen einer Testmessung, wenn die zumindest eine Testmessung nicht in einem vorgegebenen Bereich des gleitenden Mittelwerts von Testmessungen für die eindeutig identifizierte ESD-Vorrichtung (302, 304, 306, 308, 310) liegt.

5. Testvorrichtung (100) gemäß einem der Ansprüche 1 bis 4, die weiter Mittel (160) aufweist zum Übertragen der zumindest einen Testmessung an einen Hostserver (202) zur Verarbeitung.

6. Testvorrichtung gemäß Anspruch 1, die weiter Mittel (140, 142) aufweist zum Durchführen zumindest einer aus Temperatur- und Feuchtigkeits-Messungen zusammen mit dem Oberflächenwiderstandstest, um eine Interpretation von Variationen bei dem Oberflüchenwiderstandstest zu unterstützen.

7. Testvorrichtung (100) gemäß einem der Ansprüche 1 bis 6, wobei das Identifikationsmittel (130) eines aus einem Barcode-Leser und einem RFID(radio frequency identification)-Tag-Leser ist.

8. Computerlesbares Medium (152), das Computercode speichert, der beim Laden (150, 154) in eine tragbare Testvorrichtung (100) für eine elektrostatische Entladungs(ESD - electrostatic discharge)-Vorrichtung die Testvorrichtung (100) anpasst, Testmessungen von einer Vielzahl von ESD-Vorrichtungen an ESD-überwachten Stationen in einer Elektronik-Herstellungs- oder Fertigungseinrichtung zu erlangen, wobei die Testvorrichtung (100) ein Megaohmmeter (100) ist und die zumindest eine Testmessung ein Oberflächenwiderstandstest ist; wobei das computerlesbare Medium umfasst:
Code zum eindeutigen Identifizieren einer ESD-Vorrichtung (302, 304, 306, 308, 310), die unter Verwendung eines Identifikationsmittels (130) getestet werden soll, das auf der Testvorrichtung (100) vorgesehen ist;
Code zum automatischen Konfigurieren des Testmittels (120', 140, 142),
das auf der Testvorrichtung (100) vorgesehen ist, abhängig von Daten, die zu der eindeutig identifizierten ESD-Vorrichtung (302, 304, 306, 308, 310) gehören;
Code zum Anpassen der Testvorrichtung (100) zum Konfigurieren der Spannung zur Verwendung für den Oberflächenwiderstandstest abhängig von der Identität der eindeutig identifizierten ESD-Vorrichtung (302, 304, 306, 308, 310);
Code zum Durchführen zumindest einer Testmessung der eindeutig identifizierten ESD-Vorrichtung (302, 304, 306, 308, 310) unter Verwendung des Testmittels (120', 140, 142), das auf der Testvorrichtung (100) vorgesehen ist; und
Code zum Speichern der zumindest einen Testmessung in einem Speichermittel (152), das auf der Testvorrichtung (100) vorgesehen ist, derart,
dass die Testvorrichtung (100) historische Information für Testmessungen der eindeutig identifizierten ESD-Vorrichtung (302, 304, 306, 308, 310) speichert.

9. Computerlesbares Medium gemäß Anspruch 8, das weiter Code aufweist zum Anpassen der Testvorrichtung (100) zum Berechnen eines gleitenden Mittelwerts von Testmessungen für die eindeutig identifizierte ESD-Vorrichtung (302, 304, 306, 308, 310).

10. Computerlesbares Medium gemäß Anspruch 9, das weiter Code aufweist zum Anpassen der Testvorrichtung (100) zum Vergleichen der zumindest einen Testmessungfür die eindeutig identifizierte ESD-Vorrichtung (302, 304, 306, 308, 310) mit dem berechneten gleitenden Mittelwert von Testmessungen.

11. Computerlesbares Medium gemäß Anspruch 10, das weiter Code aufweist zum Anpassen der Testvorrichtung (100) zum Wiederholen einer Testmessung, wenn die zumindest eine Testmessung nicht in einem vorgegebenen Bereich des gleitenden Mittelwerts von Testmessungen für die eindeutig identifizierte ESD-Vorrichtung (302, 304, 306, 308, 310) liegt.

12. Computerlesbares Medium gemäß einem der Ansprüche 8 bis 11, das weiter Code aufweist zum Anpassen der Testvorrichtung (100) zum Übertragen der zumindest einen Testmessung an einen Hostserver (202) zur Verarbeitung.

13. Computerlesbares Medium gemäß Anspruch 8, das weiter Code aufweist zum Anpassen derTestvorrichtung (100) zur Verwendung zumindest einer aus Temperatur- und Feuchtigkeits-Messungen zusammen mit dem Oberflächenwiderstandstest, um eine Interpretation von Variationen bei dem Oberflächenwiderstandstest zu unterstützen.

14. Computerlesbares Medium gemäß einem der vorhergehenden Ansprüche, wobei das Identifikationsmittel eines aus einem Barcode-Leser und einem RFID(radio frequency identification)-Tag-Leser ist, und das computerlesbare Medium weiter Code aufweist zum Anpassen der Testvorrichtung (100) zum Lesen eines Barcodes oder eines RFID-Tags, der/das eine ESD-Vorrichtung eindeutig identifiziert.

## Revendications

1. Testeur portatif (100) pour dispositifs anti-décharges électrostatiques (ESD pour "ElectroStatic Discharge") pour tester une pluralité de dispositifs anti-ESD au niveau de postes surveillés en ce qui concerne les ESD à l'intérieur d'une installation de fabrication ou d'assemblage d'électronique, ledit testeur (100) de dispositifs anti-ESD étant un mégohmmètre, le testeur (100) de dispositifs anti-ESD comprenant :
un moyen (130) d'identification destiné à identifier de manière unique un dispositif (302, 304, 306, 308, 310) anti-ESD à tester au niveau d'un ou plusieurs postes surveillés en ce qui concerne les ESD à l'intérieur de l'installation de fabrication ou d'assemblage d'électronique ;
un moyen (120', 140, 142) de test destiné à prendre au moins une mesure de test du dispositif (302, 304, 306, 308, 310) anti-ESD identifié de manière unique, dans lequel l'au moins une mesure de test est un test de résistance superficielle ;
un moyen (150, 152, 154) de configuration destiné à configurer automatiquement le moyen (120', 140, 142) de test en fonction des données associées au dispositif (302, 304, 306, 308, 310) anti-ESD identifié de manière unique ;
un moyen (102) destiné à configurer la tension à utiliser pour le test de résistance superficielle en fonction du dispositif (302, 304, 306, 308, 310) anti-ESD identifié de manière unique ; et
un moyen (152) de mémorisation destiné à mémoriser l'au moins une mesure de test de façon que le testeur (100) mémorise de l'information d'historique pour les mesures de test du dispositif (302, 304, 306, 308, 310) anti-ESD identifié de manière unique.

2. Testeur (100) selon la revendication 1, comprenant en outre un moyen (150, 152, 154) destiné à calculer une moyenne mobile des mesures de test pour le dispositif (302, 304, 306, 308, 310) anti-ESD identifié de manière unique.

3. Testeur (100) selon la revendication 2, comprenant en outre un moyen (150, 152, 154) destiné à comparer, à la moyenne mobile calculée des mesures de test, l'au moins une mesure de test pour le dispositif (302, 304, 306, 308, 310) anti-ESD identifié de manière unique.

4. Testeur (100) selon la revendication 3, comprenant en outre un moyen (120', 140, 142) destiné à répéter une mesure de test si l'au moins une mesure de test n'est pas à l'intérieur d'une plage prédéterminée de la moyenne mobile des mesures de test pour le dispositif (302, 304, 306, 308, 310) anti-ESD identifié de manière unique.

5. Testeur (100) selon l'une quelconque des revendications 1 à 4, comprenant en outre un moyen (160) destiné à transférer l'au moins une mesure de test à un serveur hôte (202) pour traitement.

6. Testeur selon la revendication 1, comprenant en outre un moyen (140, 142) destiné à prendre au moins l'une de mesures de température et d'humidité conjointement avec le test de résistance superficielle pour aider à interpréter des variations du test de résistance superficielle.

7. Testeur (100) selon l'une quelconque des revendications 1 à 6, dans lequel le moyen (130) d'identification est l'un d'un lecteur de code à barres et d'un lecteur d'étiquette d'identification par radiofréquence (RFID pour "Radio Frequency IDentification").

8. Support (152) lisible par processeur mémorisant du code informatique qui, lorsqu'il est chargé (150, 154) dans un testeur portatif (100) pour dispositifs anti-décharges électrostatiques (ESD), adapte le testeur (100) pour obtenir des mesures de test d'une pluralité de dispositifs anti-ESD au niveau de postes surveillés en ce qui concerne les ESD à l'intérieur d'une installation de fabrication ou d'assemblage d'électronique, dans lequel le testeur (100) est un mégohmmètre (100) et l'au moins une mesure de test est un test de résistance superficielle, le support lisible par processeur incluant :
du code destiné à identifier de manière unique un dispositif (302, 304, 306, 308, 310) anti-ESD à tester en utilisant un moyen (130) d'identification prévu sur le testeur (100) ;
du code destiné à configurer automatiquement le moyen (120', 140, 142) de test prévu sur le testeur (100) en fonction de données associées au dispositif (302, 304, 306, 308, 310) anti-ESD identifié de manière unique ;
du code destiné à adapter le testeur (100) pour configurer la tension à utiliser pour le test de résistance superficielle en fonction de l'identité du dispositif (302, 304, 306, 308, 310) anti-ESD identifié de manière unique ;
du code destiné à prendre au moins une mesure de test du dispositif (302, 304, 306, 308, 310) anti-ESD identifié de manière unique en utilisant le moyen (120', 140, 142) de test prévu sur le testeur (100) ; et
du code destiné à mémoriser l'au moins une mesure de test dans un moyen (152) de mémorisation prévu sur le testeur (100) de façon que le testeur (100) mémorise de l'information d'historique pour les mesures de test du dispositif (302, 304, 306, 308, 310) anti-ESD identifié de manière unique.

9. Support lisible par processeur selon la revendication 8, comprenant en outre du code destiné à adapter le testeur (100) pour calculer une moyenne mobile des mesures de test pour le dispositif (302, 304, 306, 308, 310) anti-ESD identifié de manière unique.

10. Support lisible par processeur selon la revendication 9, comprenant en outre du code destiné à adapter le testeur (100) pour comparer, à la moyenne mobile calculée des mesures de test, l'au moins une mesure de test pour le dispositif (302, 304, 306, 308, 310) anti-ESD identifié de manière unique.

11. Support lisible par processeur selon la revendication 10, comprenant en outre du code destiné à adapter le testeur (100) pour répéter une mesure de test si l'au moins une mesure de test n'est pas à l'intérieur d'une plage prédéterminée de la moyenne mobile des mesures de test pour le dispositif (302, 304, 306, 308, 310) anti-ESD identifié de manière unique.

12. Support lisible par processeur selon l'une quelconque des revendications 8 à 11, comprenant en outre du code destiné à adapter le testeur (100) pour transférer l'au moins une mesure de test à un serveur hôte (202) pour traitement.

13. Support lisible par processeur selon la revendication 8, comprenant en outre du code destiné à adapter le testeur (100) pour utiliser au moins l'une de mesures de température et d'humidité conjointement avec le test de résistance superficielle pour aider à interpréter des variations du test de résistance superficielle.

14. Support lisible par processeur selon l'une quelconque des revendications précédentes, dans lequel le moyen d'identification est l'un d'un lecteur de code à barres et d'un lecteur d'étiquette d'identification par radiofréquence (RFID), et ledit support lisible par processeur comprend en outre du code destiné à adapter le testeur (100) pour lire un code à barres ou une étiquette de RFID identifiant de manière unique un dispositif anti-ESD.
